(19) Europäisches Patentamt
European Patent Office
Office européen des brevets

(11) EP 4 592 699 A1

(12) EUROPEAN PATENT APPLICATION
published in accordance with Art. 153(4) EPC

(43) Date of publication:
30.07.2025 Bulletin 2025/31

(51) International Patent Classification (IPC):
G01R 31/52 (2020.01)    H02S 40/32 (2014.01)

(21) Application number: 23876299.1

(86) International application number:
PCT/CN2023/109357

(22) Date of filing: 26.07.2023

(87) International publication number:
WO 2024/078093 (18.04.2024 Gazette 2024/16)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 11.10.2022 CN 202211243034

(71) Applicant: Huawei Digital Power Technologies
Co., Ltd.
Shenzhen, Guangdong 518043 (CN)

(72) Inventors:
• WANG, Chen
  Shenzhen, Guangdong 518043 (CN)
• SONG, Zhengang
  Shenzhen, Guangdong 518043 (CN)
• LI, Lin
  Shenzhen, Guangdong 518043 (CN)

(74) Representative: Pfenning, Meinig & Partner mbB
Patent- und Rechtsanwälte
Theresienhöhe 11a
80339 München (DE)

(54) CASING GROUNDING DETECTION METHOD AND INVERTER

(57) The present invention discloses a housing grounding detection method and an inverter. The inverter includes a bus positive electrode, a bus negative electrode, a ground wire end, a **PID**-repaired circuit, a first detection resistor, a second detection resistor, and a housing. The first detection resistor is connected to the bus positive electrode and the housing. The second detection resistor is connected to the bus negative electrode and the housing. The repaired circuit is connected to the bus negative electrode and the housing. The inverter is connected to a power generation module. The method includes: collecting a first voltage, that is, a voltage between the housing and the ground wire end; when an absolute value of the first voltage is not greater than a voltage threshold, adjusting a second voltage through the repaired circuit, where the second voltage is a voltage between the bus negative electrode and the ground wire end; and collecting a third voltage, that is, a voltage between the housing and the ground wire end after the second voltage is adjusted, where an absolute value of a difference between the third voltage and the first voltage is not greater than a voltage difference threshold, to detect whether the housing is grounded. According to the present invention, whether the housing is grounded is determined based on a change of a voltage of the housing to the ground, and no additional detection component is added. This improves system safety.

FIG. 2

## Description

## CROSS-REFERENCE TO RELATED APPLICATIONS

This application claims priority to Chinese Patent Application No. 202211243034.4, filed with the China National Intellectual Property Administration on October 11, 2022 and entitled "HOUSING GROUNDING DETECTION METHOD AND INVERTER", which is incorporated herein by reference in its entirety.

## TECHNICAL FIELD

The present invention relates to the field of power electronics technologies, and in particular, to a housing grounding detection method and an inverter.

## BACKGROUND

Generally, a housing of an electrical device with a metal housing needs to be grounded. However, during actual applications, a problem such as omitted housing grounding, incorrect housing grounding, or a damaged ground wire usually occurs. In this case, if a fault occurs inside the electrical device, various safety accidents may occur. For example, an internal cable is shortcircuited with the housing, resulting in an energized housing; or the housing is not grounded, resulting in conducted interference or radiation interference of an electromagnetic compatibility (electromagnetic compatibility, EMC) design exceeding a threshold, and having severe impact on a surrounding environment.

In addition, a power generation module is prone to generate potential induced degradation (potential induced degradation, PID) effect in a damp environment, and power degradation occurs under an action of a bias voltage, affecting power output of an entire power generation system. Therefore, a voltage is usually applied to the ground at a negative electrode of the power generation module through a PID-repaired circuit, to reduce impact of the PID effect of the power generation module on the power generation module. If the housing is not grounded, the PID-repaired circuit does not function, and the power generation module cannot obtain a PID compensation voltage. If an additional detection component is added to a conventional inverter structure, a system risk increases and an operation is complex.

Based on this, how to detect, without adding the additional detection component, whether a housing of an inverter is grounded is an urgent problem to be resolved currently.

## SUMMARY

The present invention provides a housing grounding detection method and an inverter, to resolve a problem of detecting housing grounding of the inverter without adding an additional detection component.

According to a first aspect, an embodiment of the present invention provides a housing grounding detection method, applied to an inverter, where the inverter includes a bus positive electrode, a bus negative electrode, a ground wire end, a PID potential induced degradation-repaired circuit, a first detection resistor, a second detection resistor, and a housing, the first detection resistor is connected between the bus positive electrode and the housing, the second detection resistor is connected between the bus negative electrode and the housing, the PID-repaired circuit is connected between the bus negative electrode and the housing, the inverter is connected to a power generation module, and the method includes:

collecting a first voltage, where the first voltage is a voltage between the housing and the ground wire end;
when an absolute value of the first voltage is less than or equal to a specified voltage threshold, adjusting a second voltage through the PID-repaired circuit, where the second voltage is a voltage between the bus negative electrode and the ground wire end; and
collecting a third voltage, where the third voltage is a voltage between the housing and the ground wire end after the second voltage is adjusted, and when an absolute value of a difference between the third voltage and the first voltage is less than or equal to a specified voltage difference threshold, the third voltage is used to detect whether the housing is grounded.

Based on the technical solution provided in the present invention, the voltage between the bus negative electrode and the ground wire end is compared with the specified voltage threshold, to detect whether the housing is grounded. The voltage threshold may be a voltage threshold specified in consideration of a housing grounding voltage or a voltage threshold specified in comprehensive consideration of a housing grounding voltage and a sampling error. During actual application, the power generation module has an equivalent resistance of a leakage current to the ground. If a ratio of an equivalent resistance value of a positive electrode of the power generation module to the ground to an equivalent resistance value of a negative electrode of the power generation module to the ground is equal to a ratio of a resistance value of the first detection resistor to a resistance value of the second detection resistor, because a power generation voltage of the power generation module is approximately equal to a bus voltage, the voltage between the bus negative electrode and the ground wire end is equal to a voltage between the bus negative electrode and the housing. Therefore, even if a measured absolute value of the voltage between the housing and the ground wire end is less than or equal to the specified voltage threshold, it cannot be proved that the housing is grounded. In this solution, a voltage of the bus negative electrode to the ground is further adjusted, to change a voltage of the housing to the ground. Whether the housing is grounded can be accurately determined based on a changing value of the voltage between the housing and the ground wire end. In the technical solution provided in the present invention, no additional detection component is added, and whether the housing is grounded can be accurately determined by using a component configured in a conventional inverter and the grounding detection method provided in the present invention.

In a possible implementation, when the absolute value of the first voltage is greater than the voltage difference threshold, the first voltage is used to detect whether the housing is grounded, and when the absolute value of the difference between the third voltage and the first voltage is greater than the voltage threshold, the third voltage is further used to detect whether the housing is grounded.

Based on the technical solution provided in the present invention, the equivalent resistance, formed during grounding of the power generation module, of the leakage current to the ground affects the following case: That the housing is grounded is detected by using the absolute value that is of the first voltage and that is less than or equal to the voltage threshold; and does not affect the following case: That the housing is not grounded is detected by using the absolute value that is of the first voltage and that is greater than the voltage threshold. In a normal operating state, an absolute value of the voltage of the housing to the ground should be equal to the voltage threshold. Therefore, when the absolute value of the first voltage is greater than the voltage threshold, it may be detected that the housing is not grounded. In addition, when the absolute value of the difference between the third voltage and the first voltage is greater than the voltage difference threshold, that is, after the voltage of the bus negative electrode to the ground is adjusted, the voltage of the housing to the ground changes accordingly, and it may also be detected that the housing is not grounded.

In a possible implementation, the inverter further includes a live wire end and a neutral wire end, and the collecting a first voltage includes:

collecting a live wire end voltage and a first sub-voltage, where the first sub-voltage is a voltage between the housing and the neutral wire end; and calculating a second sub-voltage based on the live wire end voltage, where the second sub-voltage is a voltage between the neutral wire end and the ground wire end; and calculating the first sub-voltage and the second sub-voltage to obtain the first voltage.

Based on the technical solution provided in the present invention, because a neutral wire end voltage may not be zero when three phase voltages of the live wire end are unbalanced, a voltage of the neutral wire end to the ground needs to be calculated based on the live wire end voltage. For example, the voltage between the neutral wire end and the ground wire end may be calculated by using a vector synthesis method. Further, the collected voltage between the housing and the neutral wire end and the voltage of the neutral wire end to the ground are calculated to obtain the voltage of the housing to the ground.

In a possible implementation, the PID-repaired circuit includes a switch device and a compensation power supply, the switch device is connected in series to the compensation power supply, and before the collecting a first voltage, the method further includes: control the switch device to be turned off.

In a possible implementation, the adjusting a second voltage through the PID-repaired circuit includes: controlling the switch device to be turned on, and controlling the compensation power supply to adjust the second voltage.

Based on the technical solution provided in the present invention, to adjust the voltage of the bus negative electrode to the ground and further determine a changing amount of the voltage of the housing to the ground, an operating state of the PID-repaired circuit needs to be changed. That is, before the first voltage is collected, the compensation power supply does not provide compensation, and when the voltage of the bus negative electrode to the ground needs to be adjusted, the compensation power supply is used to perform compensation.

Based on the technical solution provided in the present invention, to not add an additional component, a configuration component of the inverter needs to be used to adjust the voltage between the bus negative electrode and the ground wire end. For example, for a photovoltaic inverter, a PID-repaired circuit is designed and is configured to when incident light is sufficient, not compensate for the voltage of the bus negative electrode to the ground; and when incident light is insufficient, compensate for the voltage of the bus negative electrode to the ground, to resolve a potential induced degradation problem. Therefore, in this solution, the PID-repaired circuit of the photovoltaic inverter may be used to adjust the voltage of the bus negative electrode to the ground. The housing grounding detection method provided in this embodiment of the present invention can ensure detection precision and is easy to operate, no additional component needs to be added, and costs are reduced.

According to a second aspect, an embodiment of the present invention provides an inverter, where the inverter includes a bus positive electrode, a bus negative electrode, a ground wire end, a PID-repaired circuit, a first detection resistor, a second detection resistor, and a housing, the first detection resistor is connected between the bus positive electrode and the housing, the second detection resistor is connected between the bus negative electrode and the housing, the PID-repaired circuit is connected between the bus negative electrode and the housing, the inverter is connected to a power generation module, and the inverter further includes:

a sampling circuit, configured to collect a first voltage, where the first voltage is a voltage between the housing and the ground wire end;
a controller, configured to: when an absolute value of the first voltage is less than or equal to a specified voltage threshold, adjust a second voltage through the PID-repaired circuit, where the second voltage is a voltage between the bus negative electrode and the ground wire end; and
the sampling circuit is further configured to collect a third voltage, where the third voltage is a voltage between the housing and the ground wire end after the second voltage is adjusted, and when an absolute value of a difference between the third voltage and the first voltage is less than or equal to a specified voltage difference threshold, the third voltage is used to detect whether the housing is grounded.

According to the absolute value of the difference between the third voltage and the first voltage, in a possible implementation, when the absolute value of the first voltage is greater than the voltage difference threshold, the first voltage is used to detect whether the housing is grounded, and when the absolute value of the difference between the third voltage and the first voltage is greater than the voltage threshold, the third voltage is further used to detect whether the housing is grounded.

In a possible implementation, the inverter further includes a live wire end and a neutral wire end, and the sampling circuit collects the first voltage by using the following method:

collecting a live wire voltage and a first sub-voltage, where the first sub-voltage is a voltage between the housing and the neutral wire end; and
calculating a second sub-voltage based on the live wire voltage, where the second sub-voltage is a voltage between the neutral wire end and the ground wire end; and calculating the first sub-voltage and the second sub-voltage to obtain the first voltage.

In a possible implementation, the PID-repaired circuit includes a switch device and a compensation power supply, the switch device is connected in series to the compensation power supply, and before collecting the first voltage, the inverter is further configured to: control the switch device to be turned off.

In a possible implementation, the inverter is specifically configured to:
control the switch device to be turned on, and adjust the second voltage by using the compensation power supply.

## BRIEF DESCRIPTION OF DRAWINGS

FIG. 1 is a diagram of a structure of an inverter system;
FIG. 2 is a schematic flowchart of a housing grounding detection method according to an embodiment of the present invention;
FIG. 3 is a diagram of a structure of an inverter system according to an embodiment of the present invention; and
FIG. 4 is a diagram of a structure of an inverter according to an embodiment of the present invention.

## DESCRIPTION OF EMBODIMENTS

To make objectives, technical solutions, and advantages of the present invention clearer, the following clearly and completely describes the technical solutions in embodiments of the present invention with reference to the accompanying drawings in embodiments of the present invention.

For ease of understanding embodiments of the present invention, the following first describes technical terms included in embodiments of the present invention.

I. Potential induced degradation (potential induced degradation, PID)

The PID effect means a phenomenon that when a high bias voltage exists between an electrode and a frame of a photovoltaic module, sodium ions in glass migrate and attach to a surface of a cell, causing a power decrease of the photovoltaic module. In practice, when the photovoltaic module has a negative bias voltage, a potential of the frame of the photovoltaic module is zero, and is higher than a potential of the cell. When there is moisture or dew on a glass surface, a charged water film is formed on a surface of the module. A simulated electric field is formed between the charged water film and the cell due to a potential difference. In addition, the sodium ion has a positive charge. Therefore, under an action of the electric field, the sodium ion moves toward the cell through a packaging material, and a large quantity of charges accumulate on the surface of the cell, making the cell surface passivated. Further, power of an inverter is degraded sharply, reducing output power of a power station and reducing an energy yield.

II. Ground impedance of a photovoltaic module

The ground impedance of a photovoltaic module means an equivalent resistance of a leakage current of the photovoltaic module to the ground in a photovoltaic inverter system. For example, when a photovoltaic inverter operates, a DC input side is connected to the photovoltaic module. In an ideal operating condition, the photovoltaic module is floating. However, in a special operating condition such as rain, snow, or fog, the equivalent resistance of the photovoltaic module to the ground may decrease.

It should be understood that the terms "first" and "second" in embodiments of the present invention are merely used for a purpose of description, and shall not be understood as an indication or implication of relative importance or an implicit indication of a quantity of indicated technical features. Therefore, a feature limited by "first" or "second" may explicitly or implicitly include one or more features. For example, "the first voltage", "the second voltage", and "the third voltage" merely indicate different voltages as an example, and do not mean that importance degrees or priorities of the voltages are different.

In addition, it should be understood that "at least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. "At least one of the following items (pieces)" or a similar expression thereof means any combination of these items, including a single item (piece) or any combination of a plurality of items (pieces). For example, at least one item (piece) of a, b, or c may indicate a, b, and c, a and b, a and c, b and c, or a, b, and c.

Currently, a housing of an electrical device with a metal housing needs to be grounded. A problem such as omitted housing grounding, incorrect housing grounding, or a damaged ground wire end causes various safety accidents. In addition, a power generation module is prone to generate PID effect in a damp environment, and power degradation occurs under an action of a bias voltage, affecting power output of an entire power generation system. Therefore, a voltage is usually applied to the ground at a negative electrode of the power generation module through a PID-repaired circuit, to reduce impact of the PID effect of the power generation module on the power generation module. If the housing is not grounded, a PID compensation function fails. Therefore, whether the housing is grounded needs to be accurately detected, to avoid a subsequent safety problem.

In a current detection solution, a primary side of an optical coupler is used to obtain power between a mains live wire and a housing, and a secondary side of the optical coupler generates high-level and low-level signals for detection by a control circuit. If it is detected that the secondary side of the optical coupler is at a low level, it is detected that the housing is grounded; or if it is detected that the secondary side of the optical coupler is at a high level, it is detected that the housing is not grounded. In another solution, a non-isolated device, for example, a bipolar transistor or a MOS transistor may be used to replace the optical coupler, to detect whether the housing is grounded. However, if an additional detection component is added to a conventional inverter structure, a system risk increases and an operation is complex.

Based on the foregoing problem, an embodiment of the present invention provides a housing grounding detection method and an inverter, to detect housing grounding of the inverter without adding an additional detection component.

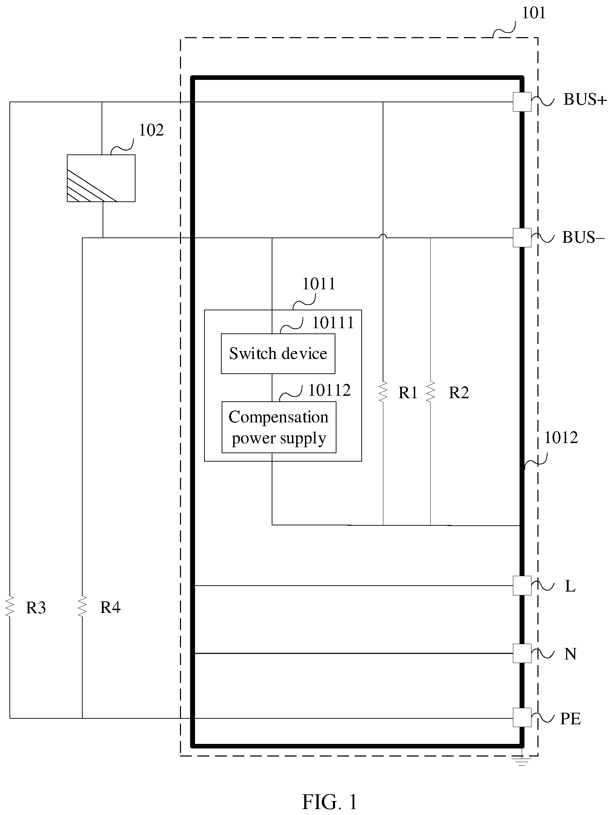

FIG. 1 is a diagram of a structure of an inverter system. As shown in FIG. 1, the inverter system includes an inverter 101 and a power generation module 102. The inverter 101 includes a bus positive electrode BUS+, a bus negative electrode BUS-, a live wire end L, a neutral wire end N, a ground wire end PE, a PID-repaired circuit 1011, a first detection resistor R1, a second detection resistor R2, and a housing 1012.

The first detection resistor R1 is connected between the bus positive electrode BUS+ and the housing 1012, the second detection resistor R2 is connected between the bus negative electrode BUS- and the housing 1012, the PID-repaired circuit 1011 is connected between the bus negative electrode BUS- and the housing 1012, and the inverter 101 is connected to the power generation module 102, where a positive electrode of the power generation module 102 is connected to the bus positive electrode BUS+, and a negative electrode of the power generation module 102 is connected to the bus negative electrode BUS-.

In addition, as shown in FIG. 1, an equivalent resistance of a leakage current to the ground exists in the power generation module 102, the inverter system further includes a first equivalent resistor R3 formed between the positive electrode of the power generation module 102 and the ground end PE, and a second equivalent resistor R4 formed between the negative electrode of the power generation module 102 and the ground end PE. The PID-repaired circuit 1011 includes a switch device 10111 and a compensation power supply 10112, and the switch device 10111 is connected in series to the compensation power supply 10112.

The following describes, with reference to the foregoing described application scenario and the accompanying drawings, the housing grounding detection method provided in an example implementation of the present invention. It should be noted that the foregoing application scenario is merely shown for ease of understanding the spirit and principle of the present invention, and the implementation of the present invention is not limited in this aspect.

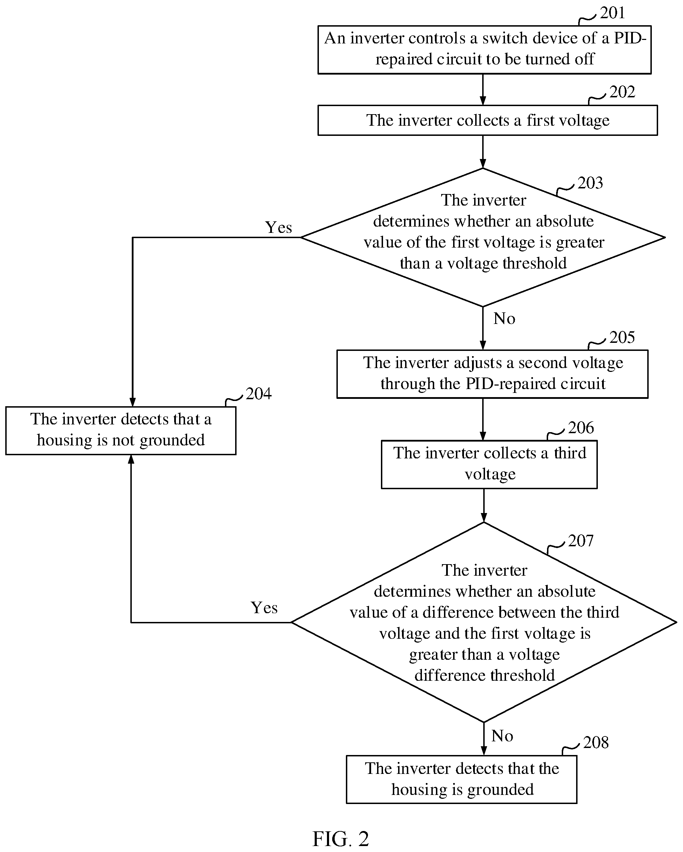

FIG. 2 is a schematic flowchart of a housing grounding detection method according to an embodiment of the present invention. The method may be applied to the inverter 101 in the inverter system shown in FIG. 1, and the method includes the following steps.

Step 201: An inverter controls a switch device of a PID-repaired circuit to be turned off.

In the subsequent steps, a voltage of a bus negative electrode to the ground needs to be adjusted, and a changing amount of a voltage of a housing to the ground needs to be further determined. Therefore, the switch device 10111 needs to be controlled to change an operating state of the PID-repaired circuit 1011. That is, before step 202 is performed, the compensation power supply 10112 does not provide compensation, and when the voltage of the bus negative electrode BUS- to the ground needs to be adjusted, the compensation power supply 10112 is used to perform compensation.

It should be noted that, that the inverter 101 controls the switch device 10111 to be turned off may be maintaining the switch device 10111 to be in an off state, or may be turning off the turned-on switch device 10111.

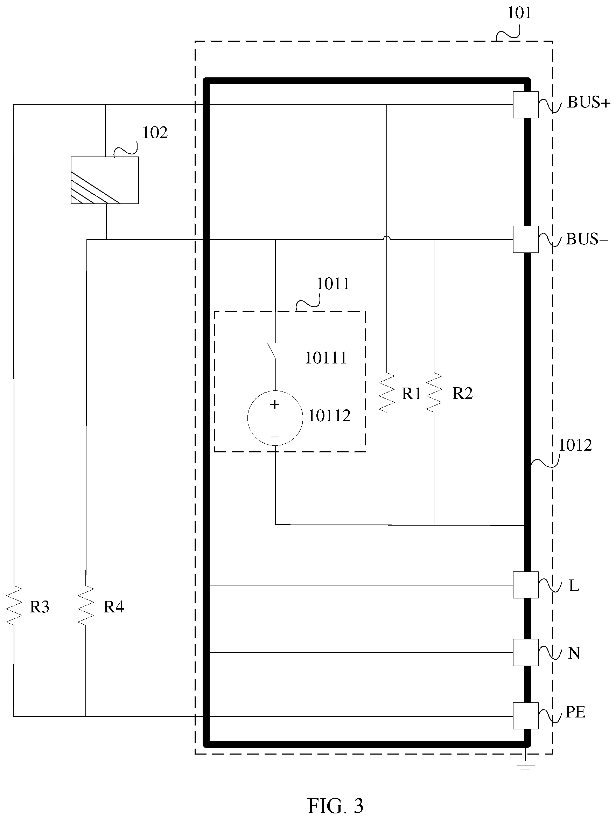

In a possible embodiment, without adding an additional component, a compensation circuit that can change the voltage of the bus negative electrode BUS- to the ground and that is in the inverter system may be used as the PID-repaired circuit. For example, FIG. 3 is a diagram of a structure of the inverter system according to an embodiment of the present invention. As shown in FIG. 3, if the inverter system is a photovoltaic inverter system, the switch device 10111 may be a relay, and the compensation power supply 10112 is a voltage source.

Step 202: The inverter collects a first voltage.

It should be noted that the first voltage is a voltage between a housing 1012 and a ground wire end PE, and the first voltage is obtained through sampling and calculation.

In an embodiment, the inverter may collect the first voltage through the following steps A1 to A3.

A1: The inverter 101 collects a live wire voltage and a first sub-voltage, where the first sub-voltage is a voltage between the housing 1012 and a neutral wire end N.
A2: The inverter 101 calculates a second sub-voltage based on the live wire voltage, where the second sub-voltage is a voltage between the neutral wire end N and the ground wire end PE. The live wire voltage is a mains voltage. A calculation method may be used based on an actual circuit situation. For example, in a case of a three-phase imbalance, the second sub-voltage may be calculated based on the live wire voltage by using a vector synthesis method.
A3: The inverter 101 calculates the first sub-voltage and the second sub-voltage to obtain the first voltage.

In addition, a collection manner of a third voltage in the following is similar to a collection manner of the first voltage, and details are not described again subsequently.

Step 203: The inverter determines whether an absolute value of the first voltage is greater than a voltage threshold; and if the inverter determines that the absolute value of the first voltage is greater than the voltage threshold, step 204 is performed; or if the inverter determines that the absolute value of the first voltage is not greater than the voltage threshold, step 205 is performed.

Optionally, the voltage threshold may be set based on the voltage between the housing 1012 and the ground wire end PE in a housing grounding state; or the voltage threshold may be set in comprehensive consideration of an error factor such as voltage sampling. For example, in an ideal grounding state, the voltage between the housing 1012 and the ground wire end PE is zero, and the voltage threshold may be set to zero; or in consideration of a sampling error, the voltage threshold is set to zero approximately.

Step 204: The inverter detects that the housing is not grounded.

In a possible embodiment, after detecting that the housing is not grounded, the inverter may give an alarm through display or sound prompt. In the following, after it is detected that the housing is grounded, an alarm process is similar, and details are not described again.

Step 205: The inverter adjusts a second voltage through the PID-repaired circuit.

It should be noted that the second voltage is a voltage between the bus negative electrode BUS- and the ground wire end PE. The second voltage is obtained through sampling.

In addition, because a first equivalent resistor R3 and a second equivalent resistor R4 exist, when the housing 1012 is not grounded, the voltage of the bus negative electrode BUS- to the ground is not affected by internal impedance of the inverter 101, and the inverter 101 may determine the voltage between the bus negative electrode BUS- and the ground wire end PE according to the following formula:

$$U_1 = U_{pv} \times \frac{r_4}{(r_3 + r_4)}$$

$U_1$ is the voltage between the bus negative electrode BUS- and the ground wire end PE, $U_{pv}$ is a power generation voltage of the power generation module 102, $r_3$ is a resistance value of the first equivalent resistor R3, and $r_4$ is a resistance value of the second equivalent resistor R4.

Further, when the housing 1012 is not grounded, the voltage between the bus negative electrode BUS- and the housing 1012 may be determined according to the following formula:

$$U_2 = U_{BUS} \times \frac{r_2}{(r_1 + r_2)}$$

$U_2$ is the voltage between the bus negative electrode BUS- and the housing 1012, $U_{BUS}$ is a total bus voltage, $r_1$ is a resistance value of the first detection resistor R1, and $r_2$ is a resistance value of the second detection resistor R2.

Generally, $U_{py}$ is equal to a voltage of the bus negative electrode BUS-, and a ratio of $r_2$ to $r_1$ is not equal to a ratio of $r_3$ to $r_4$. In this way, when the first voltage is less than or equal to the voltage threshold, it may be detected that the housing 1012 is grounded. However, in a special case, for example, an equivalent resistance value of the power generation module 102 to the ground that is affected by an operating condition changes, and the ratio of $r_2$ to $r_1$ may be equal to the ratio of $r_3$ to $r_4$. Therefore, when the first voltage is less than or equal to the voltage threshold, it cannot be proved that the housing 1012 is grounded.

Therefore, the voltage (that is, the second voltage) of the bus negative electrode BUS-to the ground needs to be adjusted, and whether the housing is grounded is further detected based on a changing value of the voltage of the housing 1012 to the ground.

In a possible embodiment, the inverter may control the switch device 10111 to be turned on, to control the compensation power supply 10112 to adjust the second voltage.

Step 206: The inverter collects a third voltage.

It should be noted that the third voltage is a voltage between the housing and the ground wire end after the second voltage is adjusted.

Step 207: The inverter determines whether an absolute value of a difference between the third voltage and the first voltage is greater than a voltage difference threshold; and if the inverter determines that the absolute value of the difference between the third voltage and the first voltage is greater than the voltage difference threshold, step 204 is performed; or if the inverter determines that the absolute value of the difference between the third voltage and the first voltage is not greater than the voltage difference threshold, step 208 is performed.

It should be noted that when the housing is not grounded, the voltage between the bus negative electrode BUS- and the ground wire end PE is adjusted, and the voltage between the housing 1012 and the ground wire end PE changes. When the housing 1012 is grounded, the voltage between the bus negative electrode BUS- and the ground wire end PE is adjusted, and the voltage between the housing 1012 and the ground wire end PE does not change, or changes slightly (when an error is considered).

Therefore, the voltage difference threshold may be set based on a changing value of the voltage between the housing 1012 and the ground wire end PE. For example, in an ideal grounding state, the changing value of the voltage between the housing 1012 and the ground wire end PE is zero, and the voltage difference threshold may be set to zero; or in consideration of a sampling error, the voltage difference threshold is set to zero approximately.

Step 208: The inverter detects that the housing is grounded.

In conclusion, in the technical solution provided in the present invention, the voltage between the bus negative electrode and the ground wire end is adjusted by using a configured component of the inverter, and a grounding state of the housing of the inverter can be accurately determined based on a changing value of the voltage of the bus negative electrode to the ground. Therefore, the housing grounding detection method disclosed in the present invention can ensure detection precision and is easy to operate, no additional component needs to be added, and costs are low.

Based on a same inventive concept, an embodiment of the present invention further provides an inverter. The inverter may be used in the housing grounding detection method that is shown in FIG. 2 or that is similar to the implementation of FIG. 2. The following further describes an inverter provided in the present invention with reference to the accompanying drawings and the foregoing housing grounding detection method.

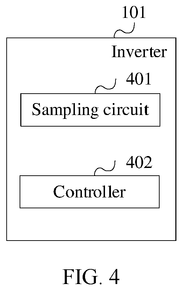

FIG. 4 is a diagram of a structure of an inverter according to an embodiment of the present invention. As shown in FIG. 4, in addition to the circuit structure shown in FIG. 1, the inverter 101 further includes a sampling circuit 401 and a controller 402. The sampling circuit 401 is configured to collect a first voltage and a third voltage, where the first voltage is a voltage between a housing and a ground wire end, and the third voltage is a voltage between the housing and the ground wire end after a second voltage is adjusted.

In a possible embodiment, the sampling circuit 401 collects the first voltage by using the following method.

The sampling circuit 401 collects a live wire voltage and a first sub-voltage, where the first sub-voltage is a voltage between the housing and a neutral wire end. The sampling circuit 401 calculates a second sub-voltage based on the live wire voltage, and calculates the first sub-voltage and the second sub-voltage, to obtain the first voltage, where the second sub-voltage is a voltage between the neutral wire end and the ground wire end.

The controller 402 is configured to: before collecting the first voltage, control a switch device to be turned off; detect, based on an absolute value that is of the first voltage and that is greater than a voltage threshold, whether the housing is grounded; control, based on an absolute value that is of the first voltage and that is less than or equal to the voltage threshold, the switch device to be turned on, and adjust the second voltage by using a compensation power supply, where the second voltage is a voltage between a bus negative electrode and the ground wire end; and detect, based on an absolute value that is of a difference between the third voltage and the first voltage and that is less than or equal to a specified voltage difference threshold, whether the housing is grounded.

Based on the descriptions of the implementations, a person skilled in the art may understand that for the purpose of convenient and brief descriptions, division into the functional modules is merely used as an example for description. During actual application, the functions can be allocated to different functional modules for implementation based on a requirement. In other words, an inner structure of an apparatus is divided into different functional modules, to implement all or some of the foregoing described functions.

In the several embodiments provided in the present invention, it should be understood that the disclosed module, unit, and method may be implemented in other manners. For example, the described module embodiment and unit embodiment are merely examples. For example, division into the modules or the units is merely logical function division and may be other division during actual implementation. For example, a plurality of units or components may be combined or integrated into another apparatus, or some features may be ignored or not performed. In addition, the displayed or discussed mutual couplings or direct couplings or communication connections may be implemented through some interfaces. The indirect couplings or communication connections between the modules or the units may be implemented in an electrical form, a mechanical form, or another form.

The units described as separate parts may or may not be physically separate, and parts displayed as units may be one or more physical units, may be located in one place, or may be distributed in different places. Some or all of the units may be selected based on actual requirements to achieve the objectives of the solutions of embodiments.

In addition, functional units in embodiments of the present invention may be integrated into one processing unit, or each of the units may exist alone physically, or two or more units are integrated into one unit. The integrated unit may be implemented in a form of hardware, or may be implemented in a form of a software functional unit.

When the integrated unit is implemented in the form of a software functional unit and sold or used as an independent product, the integrated unit may be stored in a readable storage medium. Based on such an understanding, the technical solutions of embodiments of the present invention essentially, or the part contributing to the conventional technology, or all or some of the technical solutions may be implemented in a form of a software product. The software product is stored in a storage medium and includes several instructions for instructing a device (which may be a single-chip microcomputer, a chip, or the like) or a processor (processor) to perform all or some of the steps of the methods described in embodiments of the present invention. The foregoing storage medium includes any medium that can store program code such as a USB flash drive, a removable hard disk, a read-only memory (read-only memory, ROM), a random access memory (random access memory, RAM), a magnetic disk, or an optical disc.

To make the objectives, technical solutions, and advantages of the present invention clearer, the following further describes the present invention in detail with reference to the accompanying drawings. A specific operation method in a method embodiment may also be applied to an inverter embodiment or a system embodiment. In the descriptions of the present invention, unless otherwise stated, "a plurality of" means two or more than two.

Optionally, the computer-executable instructions in this embodiment of the present invention may also be referred to as application program code. This is not specifically limited in this embodiment of the present invention.

All or some of the foregoing embodiments may be implemented by using software, hardware, firmware, or any combination thereof. When software is used to implement the embodiments, all or some of the embodiments may be implemented in a form of a computer program product. The computer program product includes one or more computer instructions. When the computer program instructions are loaded and executed on a computer, all or some procedures or functions in embodiments of the present invention are generated. The computer may be a general-purpose computer, a dedicated computer, a computer network, or another programmable apparatus. The computer instructions may be stored in a computer-readable storage medium, or may be transmitted from one computer-readable storage medium to another computer-readable storage medium.

The various illustrative logical units and circuits described in embodiments of the present invention may implement or operate the described functions by using a general-purpose processor, a digital signal processor, an application-specific integrated circuit (ASIC), a field programmable gate array (FPGA) or another programmable logical apparatus, a discrete gate or transistor logic, a discrete hardware component, or a design of any combination thereof. The general-purpose processor may be a microprocessor. Optionally, the general-purpose processor may be any conventional processor, controller, microcontroller, or state machine. The processor may alternatively be implemented by a combination of computing apparatuses, for example, a digital signal processor and a microprocessor, a plurality of microprocessors, one or more microprocessors and a digital signal processor core, or any other similar configuration.

Steps of the methods or algorithms described in embodiments of the present invention may be directly embedded into hardware, a software unit executed by a processor, or a combination thereof. The software unit may be stored in a RAM memory, a flash memory, a ROM memory, an EPROM memory, an EEPROM memory, a register, a hard disk, a removable magnetic disk, a CD-ROM, or a storage medium of any other form in the art. For example, the storage medium may be connected to the processor, so that the processor may read information from the storage medium and may write information to the storage medium. Optionally, the storage medium may be integrated into a processor. The processor and the storage medium may be disposed in the ASIC.

These computer program instructions may also be loaded onto a computer or another programmable data processing device, so that a series of operations and steps are performed on the computer or the another programmable device, thereby generating computer-implemented processing. Therefore, the instructions executed on the computer or the another programmable device provide steps for implementing a specific function in one or more processes in the flowcharts and/or in one or more blocks in the block diagrams.

Although the present invention is described with reference to specific features and embodiments thereof, apparently, various modifications and combinations may be made to them without departing from the spirit and scope of the present invention. Correspondingly, this specification and accompanying drawings are merely example descriptions of the present invention defined by the accompanying claims, and are considered as any or all modifications, variations, combinations or equivalents that cover the scope of the present invention. Apparently, a person skilled in the art can make various modifications and variations to the present invention without departing from the scope of the present invention. The present invention is intended to cover these modifications and variations of the present invention provided that they fall within the scope of protection defined by the following claims of the present invention and their equivalent technologies.

**Claims**

1. A housing grounding detection method, applied to an inverter, wherein the inverter comprises a bus positive electrode, a bus negative electrode, a ground wire end, a **PID** potential induced degradation-repaired circuit, a first detection resistor, a second detection resistor, and a housing, the first detection resistor is connected between the bus positive electrode and the housing, the second detection resistor is connected between the bus negative electrode and the housing, the PID-repaired circuit is connected between the bus negative electrode and the housing, the inverter is connected to a power generation module, and the method comprises:

    collecting a first voltage, wherein the first voltage is a voltage between the housing and the ground wire end;
    when an absolute value of the first voltage is less than or equal to a specified voltage threshold, adjusting a second voltage through the PID-repaired circuit, wherein the second voltage is a voltage between the bus negative electrode and the ground wire end; and
    collecting a third voltage, wherein the third voltage is a voltage between the housing and the ground wire end after the second voltage is adjusted, and when an absolute value of a difference between the third voltage and the first voltage is less than or equal to a specified voltage difference threshold, the third voltage is used to detect whether the housing is grounded.

2. The method according to claim 1, wherein when the absolute value of the first voltage is greater than the voltage difference threshold, the first voltage is used to detect whether the housing is grounded, and when the absolute value of the difference between the third voltage and the first voltage is greater than the voltage threshold, the third voltage is further used to detect whether the housing is grounded.

3. The method according to claim 1 or 2, wherein the inverter further comprises a live wire end and a neutral wire end, and the collecting a first voltage comprises:

    collecting a live wire voltage and a first sub-voltage, wherein the first sub-voltage is a voltage between the housing and the neutral wire end;
    calculating a second sub-voltage based on the live wire voltage, wherein the second sub-voltage is a voltage between the neutral wire end and the ground wire end; and
    calculating the first sub-voltage and the second sub-voltage to obtain the first voltage.

4. The method according to any one of claims 1 to 3, wherein the PID-repaired circuit comprises a switch device and a compensation power supply, the switch device is connected in series to the compensation power supply, and before the collecting a first voltage, the method further comprises:
    controlling the switch device to be turned off.

5. The method according to claim 4, wherein the adjusting a second voltage through the PID-repaired circuit comprises:
    controlling the switch device to be turned on, and controlling the compensation power supply to adjust the second voltage.

6. An inverter, wherein the inverter comprises a bus positive electrode, a bus negative electrode, a ground wire end, a PID-repaired circuit, a first detection resistor, a second detection resistor, and a housing, the first detection resistor is connected between the bus positive electrode and the housing, the second detection resistor is connected between the bus negative electrode and the housing, the PID-repaired circuit is connected between the bus negative electrode and the housing, and the inverter is connected to a power generation module; the inverter further comprises:

> a sampling circuit, configured to collect a first voltage, wherein the first voltage is a voltage between the housing and the ground wire end; and
> a controller, configured to: when an absolute value of the first voltage is less than or equal to a specified voltage threshold, adjust a second voltage through the PID-repaired circuit, wherein the second voltage is a voltage between the bus negative electrode and the ground wire end; and
> the sampling circuit is further configured to collect a third voltage, wherein the third voltage is a voltage between the housing and the ground wire end after the second voltage is adjusted, and when an absolute value of a difference between the third voltage and the first voltage is less than or equal to a specified voltage difference threshold, the third voltage is used to detect whether the housing is grounded.

7. The inverter according to claim 6, wherein when the absolute value of the first voltage is greater than the voltage difference threshold, the first voltage is used to detect whether the housing is grounded, and when the absolute value of the difference between the third voltage and the first voltage is greater than the voltage threshold, the third voltage is further used to detect whether the housing is grounded.

8. The inverter according to claim 6 or 7, wherein the inverter further comprises a live wire end and a neutral wire end, and the sampling circuit collects the first voltage by using the following method:

> collecting a live wire voltage and a first sub-voltage, wherein the first sub-voltage is a voltage between the housing and the neutral wire end; and
> calculating a second sub-voltage based on the live wire voltage, wherein the second sub-voltage is a voltage between the neutral wire end and the ground wire end; and calculating the first sub-voltage and the second sub-voltage to obtain the first voltage.

9. The inverter according to any one of claims 6 to 8, wherein the PID-repaired circuit comprises a switch device and a compensation power supply, the switch device is connected in series to the compensation power supply, and before collecting the first voltage, the controller is further configured to:
control the switch device to be turned off.

10. The inverter according to claim 9, wherein the controller is specifically configured to:
control the switch device to be turned on, and adjust the second voltage through the compensation power supply.

101

BUS+

102

BUS−

1011

10111

Switch device

10112

R1    R2

Compensation
power supply

1012

R3    R4

L

N

PE

FIG. 1

FIG. 2

FIG. 3

101

Inverter

401

Sampling circuit

402

Controller

FIG. 4

## INTERNATIONAL SEARCH REPORT

| | International application No. |
|---|---|
| | **PCT/CN2023/109357** |

| A. | CLASSIFICATION OF SUBJECT MATTER |
|---|---|

G01R31/52(2020.01)i; H02S40/32(2014.01)i

According to International Patent Classification (IPC) or to both national classification and IPC

| B. | FIELDS SEARCHED |
|---|---|

Minimum documentation searched (classification system followed by classification symbols)

G01R31 H02S40

Documentation searched other than minimum documentation to the extent that such documents are included in the fields searched

Electronic data base consulted during the international search (name of data base and, where practicable, search terms used)

CNTXT, CNABS, CNKI: 光伏, 逆变, 母线, 正极, 负极, 壳, 箱, 盒, 接地, 地线, 电势诱导, 电压, 电源, 补偿, 修复, 校正, 开关, 调整, 调节, 比较, 阈值, 设定值, 预设值; VEN, USTXT, WOTXT, EPTXT: photovoltaic, inverter, bus, positive electrode, negative electrode, shell, case, box, ground, earth, potential inducedde gradation, PID, voltage, power, compensate, repair, revise, emendate, switch, adjust, compare, threshold, setting value, presupposition value

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 115575852 A (HUAWEI DIGITAL POWER TECHNOLOGIES CO., LTD.) 06 January 2023 (2023-01-06) claims 1-10 | 1-10 |
| X | CN 111525887 A (AISWEI NEW ENERGY TECHNOLOGY (JIANGSU) CO., LTD.) 11 August 2020 (2020-08-11) description, paragraphs 36-45, and figures 1-2 | 1-10 |
| A | CN 111969646 A (HUAWEI TECHNOLOGIES CO., LTD.) 20 November 2020 (2020-11-20) entire document | 1-10 |
| A | CN 210323324 U (AFORE NEW ENERGY TECHNOLOGY (SHANGHAI) CO., LTD.) 14 April 2020 (2020-04-14) entire document | 1-10 |
| A | CN 105591609 A (BEIJING ETECHWIN ELECTRICAL CO., LTD.) 18 May 2016 (2016-05-18) entire document | 1-10 |

☑ Further documents are listed in the continuation of Box C.     ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **10 October 2023** | **12 October 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/109357**

### C.    DOCUMENTS CONSIDERED TO BE RELEVANT

| Category* | Citation of document, with indication, where appropriate, of the relevant passages | Relevant to claim No. |
|---|---|---|
| A | CN 106018967 A (CHANGZHOU POWER SUPPLY CO. OF STATE GRID JIANGSU ELECTRIC POWER CO. et al.) 12 October 2016 (2016-10-12)<br>entire document | 1-10 |
| A | CN 113872241 A (GOODWE TECHNOLOGY CO., LTD.) 31 December 2021 (2021-12-31)<br>entire document | 1-10 |
| A | CN 107493057 A (BEIJING APOLLO DING RONG SOLAR TECHNOLOGY CO., LTD.) 19 December 2017 (2017-12-19)<br>entire document | 1-10 |
| A | KR 20160005613 A (KD POWER CO., LTD.; PARK, K. J.) 15 January 2016 (2016-01-15)<br>entire document | 1-10 |

Form PCT/ISA/210 (second sheet) (July 2022)

**INTERNATIONAL SEARCH REPORT**
Information on patent family members

International application No.

**PCT/CN2023/109357**

| Patent document cited in search report | | | Publication date (day/month/year) | Patent family member(s) | | | Publication date (day/month/year) |
|---|---|---|---|---|---|---|---|
| CN | 115575852 | A | 06 January 2023 | None | | | |
| CN | 111525887 | A | 11 August 2020 | CN | 211830697 | U | 30 October 2020 |
| CN | 111969646 | A | 20 November 2020 | WO | 2022016919 | A1 | 27 January 2022 |
| | | | | CN | 111969646 | B | 22 July 2022 |
| | | | | US | 2023155382 | A1 | 18 May 2023 |
| | | | | EP | 4184743 | A1 | 24 May 2023 |
| CN | 210323324 | U | 14 April 2020 | None | | | |
| CN | 105591609 | A | 18 May 2016 | CN | 105591609 | B | 29 June 2018 |
| CN | 106018967 | A | 12 October 2016 | CN | 106018967 | B | 20 March 2018 |
| CN | 113872241 | A | 31 December 2021 | None | | | |
| CN | 107493057 | A | 19 December 2017 | CN | 207442731 | U | 01 June 2018 |
| KR | 20160005613 | A | 15 January 2016 | None | | | |

Form PCT/ISA/210 (patent family annex) (July 2022)

**EP 4 592 699 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211243034